(19)

**Europäisches Patentamt**

**European Patent Office**

**Office européen des brevets**

(11) **EP 4 679 104 A2**

(12) **EUROPEAN PATENT APPLICATION**

(43) Date of publication:
**14.01.2026 Bulletin 2026/03**

(51) International Patent Classification (IPC):
*G01R 23/16* (2006.01)

(21) Application number: **25220110.8**

(22) Date of filing: **22.05.2023**

(52) Cooperative Patent Classification (CPC):
**G01R 23/16; G06F 18/214; G06N 3/0464; G06N 3/09;** G06F 2218/12

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(62) Document number(s) of the earlier application(s) in accordance with Art. 76 EPC:
**23174634.8 / 4 467 995**

(71) Applicant: **Helsing GmbH**
**81671 Munich (DE)**

(72) Inventor: **NINOS, Alexandros**
**81671 Munich (DE)**

(74) Representative: **Rummler, Felix**
**Maucher Jenkins**
**Liebigstraße 39**
**80538 München (DE)**

Remarks:
This application was filed on 02.12.2025 as a divisional application to the application mentioned under INID code 62.

(54) **OBJECT CLASSIFIER FOR RADIO-FREQUENCY SIGNAL PROCESSING**

(57)     A computer-implemented method of providing a machine learning module for radiofrequency signal processing, the method comprising receiving a training dataset comprising one or more time-dependent training signals and one or more labels indicative of classifications of the training signals, performing a plurality of time-frequency transforms of the training signals to determine a plurality of time-frequency distributions, supplying the time-frequency distributions to an input of a machine learning module, and training the object classifier to classify the training signal,
characterized in that the machine learning module is a You Only Look Once image classifier.

**Fig. 1**

**Description**

**Technical Field**

The present disclosure relates to systems, methods, and computer program products for radio-frequency processing and radio devices comprising the same. The present disclosure is applicable in the field of communication, in particular wireless communication.

**Background**

A frequent problem in signal processing is the detection and classification of radio-frequency signals. For example, when using a radio device to receive a radio signal, it is a common problem to identify and/or classify a signal, a part of a signal, or a specific signal feature. A particular challenge is the detection, including the separation, and classification of signal patterns at similar frequencies arriving at the same time. Applications include detection of sending devices that interfere with each other.

Known solutions include manual extraction of features from the received radio signals. These solutions are specific to particular signals and cannot be generalized to a wide range of signals.

**Summary**

A first aspect of the present disclosure relates to a computer-implemented method of providing an object classifier for radio-frequency signal processing. The method comprises:

- receiving a training dataset comprising one or more time-dependent training signals and one or more labels indicative of classifications of the training signals;
- performing a plurality of different time-frequency transforms of the training signals to determine a plurality of time-frequency distributions;
- supplying the time-frequency distributions to an input of an object classifier; and
- training the object classifier to classify the training signal.

The use of time-frequency transforms implies conversion of the signal into a format that can be well processed by object classifier, and in particular better than when supplying the signal to the input of the object classifier itself. Moreover, using more than one time-frequency transform allows benefitting from the advantages of each of the time-frequency transforms, for example stability with regard to noise and/or nonlinearities in the signal. Disadvantages of the different time-frequency signals that are specific to a particular transform, such as numerical artifacts, affect the processing by the object classifier less since errors are practically canceled out. As a result, the object classifier is more stable with respect to noise, and better suitable for classifying and distinguishing distinct signal patterns that are situated close in time and frequency, in particular with increased accuracy and/or efficiency.

In an embodiment, the time-frequency transforms of the training signal have a constant time-frequency resolution, so that all frequency bands have the same temporal resolution, and the frequency resolution is the same for all times. Therefore, any two signals which comprise signal patterns that differ only in frequency can be classified consistently.

In a further embodiment, the time-frequency distributions include one or more spectrograms. Spectrograms are real-valued functions that depend on time and frequency. They may be determined by calculating an absolute value or square of absolute value of a complex time-frequency distribution. They can be stored as two-dimensional arrays and/or images and supplied to known image classifiers.

In a further embodiment, performing the time-frequency transforms of the training signal comprises performing a short-time Fourier transform (STFT) of the training signal. The STFT is well understood and easy to interpret, and it may be implemented in a fast and computationally efficient way, so that it allows processing in real time. Moreover, its time-frequency resolution is constant.

The method is preferred to further comprise adjusting a window size of the STFT. The window size can be used to control the time and frequency resolution. Thereby, the window size may be adjusted to improve classification of the signal patterns.

In a further embodiment, performing the time-frequency transforms of the training signal comprises performing a Capon transform of the training signal. A Capon transform may be performed by Capon beamforming and provides high resolution. It is particularly useful if the input signal has a high signal to noise ratio. It is fast enough to allow processing in real time.

In a further embodiment, performing the time-frequency transforms of the training signal comprises performing a Wigner-Ville transform of the training signal. The Wigner-Ville transform generates a Wigner-Ville distribution, WVD, and has a higher resolution than the STFT.

In a further embodiment, performing the time-frequency transforms of the training signal comprises performing a reassignment of one or more of the determined time-frequency distributions. It is preferred to include performing an STFT and/or a Capon transform of the training signal, each followed by performing a reassignment operation. In other words, the TF distribution generated by STFT may be processed by a first reassignment operation and the Capon transform may be processed by a second reassignment operation. Supplying both a time-frequency distribution, as produced by a TF transform, and the same or another time-frequency distribution after the further step of reassignment to the object classifier leads to a further increase in precision and reliability of the classification because reassignment has the effect that the time-frequency signals are closer to their true region of support.

In a further embodiment, the object classifier comprises a machine learning module, preferably a neural network, and more preferably a convolutional neural network (CNN). The object classifier is preferred to include an image classifier, more preferably a CNN-based image classifier. Image classifiers can take arrays of a defined size as input and are thus also able to process TF distributions.

A second aspect of the present disclosure relates to a computer-implemented method of radio-frequency signal processing. The method comprises:

- receiving a time-dependent input signal;
- performing a plurality of time-frequency transforms of the input signal to determine a plurality of time-frequency distributions;
- supplying the time-frequency distributions to an input of a trained object classifier; and
- classifying the input signal by the trained object classifier.

Classifying the input signal may, in particular, include obtaining an output signal indicative of a classification of the input signal. The advantages of preprocessing the input signal by the application of time-frequency transforms for classification by the trained object classifier are similar to the advantages when preprocessing a training signal for training: The TF distributions can be better processed by the object classifier than when supplying the time-dependent input signal to the input of the object classifier itself, without the preprocessing. Moreover, using more than one time-frequency transform allows benefitting from the advantages of each of the time-frequency transforms, for example stability with regard to noise and/or nonlinearities in the signal. The result of the classification is thus more stable with respect to noise. Distinct signal patterns that are situated close in time and frequency can be distinguished.

In an embodiment of the second aspect, the trained object classifier was trained using the method of the first aspect of the present disclosure. This allows using the trained object classifier for classification of similar data, with a similar preprocessing. The method can thus be seen as a test, or inference, method of a machine learning algorithm trained with the method of the first aspect.

In another embodiment of the second aspect, the time-frequency transforms of the training signal have a constant time-frequency resolution. This allows consistent classification of input signals that comprise similar or identical signal patterns that are located at different positions in time-frequency space.

In a further embodiment of the second aspect, the time-frequency distributions include one or more spectrograms. Spectrograms are real-valued functions that depend on two parameters. They can be stored as two-dimensional arrays and supplied to known image classifiers.

In yet another embodiment of the second aspect, performing the time-frequency transforms of the input signal comprises one or more of:

- performing an STFT of the input signal;
- performing a Capon transform of the input signal;
- performing a Wigner-Ville transform of the input signal;
- performing a reassignment operation on a time-frequency distribution; and/or
- performing an STFT and/or a Capon transform of the input signal followed by performing a reassignment operation.

The specific advantages of the transforms and the combinations thereof apply both for training and classification.

In yet another embodiment, the time-dependent test signal and/or the time-dependent input signal comprises a radio frequency, RF, signal, in particular an RF signal detected by an antenna.

A third aspect of the present disclosure relates to a system for providing an object classifier for radio-frequency signal processing. The system comprises one or more processors and one or more storage devices. The system is configured to perform the computer-implemented method of the first aspect of the present disclosure.

A fourth aspect of the present disclosure relates to a system for detecting a signal pattern in a time-dependent input signal. The system comprises one or more processors and one or more storage devices. The system is configured to perform the computer-implemented method of the second aspect of the present disclosure.

A fifth aspect of the present disclosure relates to a radio device. The radio device comprises the system of the fourth aspect of the present disclosure. The radio device further comprises a radio receiver that is coupled to the processor and operable to receive the time-dependent input signal.

A sixth aspect of the present disclosure relates to a computer program product for loading into a memory of a computer. The computer program product comprises instructions, that, when executed by a processor of the computer, cause the computer to execute a computer-implemented method of the first aspect and/or second aspect of the present disclosure.

The computer program product may be operable for loading into a memory of the system of the third aspect of the present disclosure. The computer program product may comprise instructions, that, when executed by a processor of the system, cause the system to execute the computer-implemented method of the first aspect of the present disclosure.

The computer program product may be operable for loading into a memory of the system of the fourth aspect of the present disclosure. The computer program product may comprise instructions, that, when executed by a processor of the system, cause the system to execute the computer-implemented method of the second aspect of the present disclosure.

In a further embodiment, a computer-readable storage medium is provided that stores instructions executable by one or more processors for detecting a signal pattern in a time-dependent input signal. The instructions comprise any of the steps of a computer-implemented method of the first aspect and/or second aspect of the present disclosure.

A seventh aspect of the present disclosure relates to a computer program product. The computer program product comprises a trained object classifier obtainable by the computer-implemented method of the first aspect of the present disclosure. The computer program product may be loaded into the memory and executed by a processor of a computer, such as the system of the fourth aspect.

### Brief description of the drawings

The features, objects, and advantages of the present disclosure will become more apparent from the detailed description set forth below when taken in conjunction with the drawings in which like reference numerals refer to similar elements.

- Figure 1 shows a flow chart of a method of providing an object classifier;
- Figure 2 shows a block diagram of a system for providing an object classifier;
- Figure 3 shows a block diagram of a training dataset;
- Figure 4 shows a flow chart of a method of radio-frequency signal processing;
- Figure 5 shows a block diagram of a system for detecting a signal pattern in a time-dependent input signal;
- Figure 6 shows a block diagram of a test dataset; and
- Figure 7 shows a block diagram of a radio device.

### Detailed description

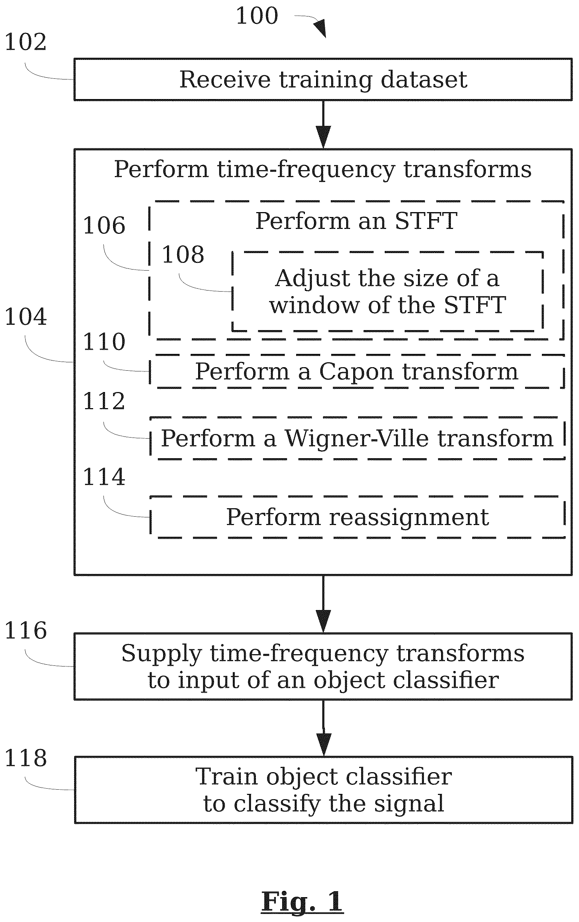

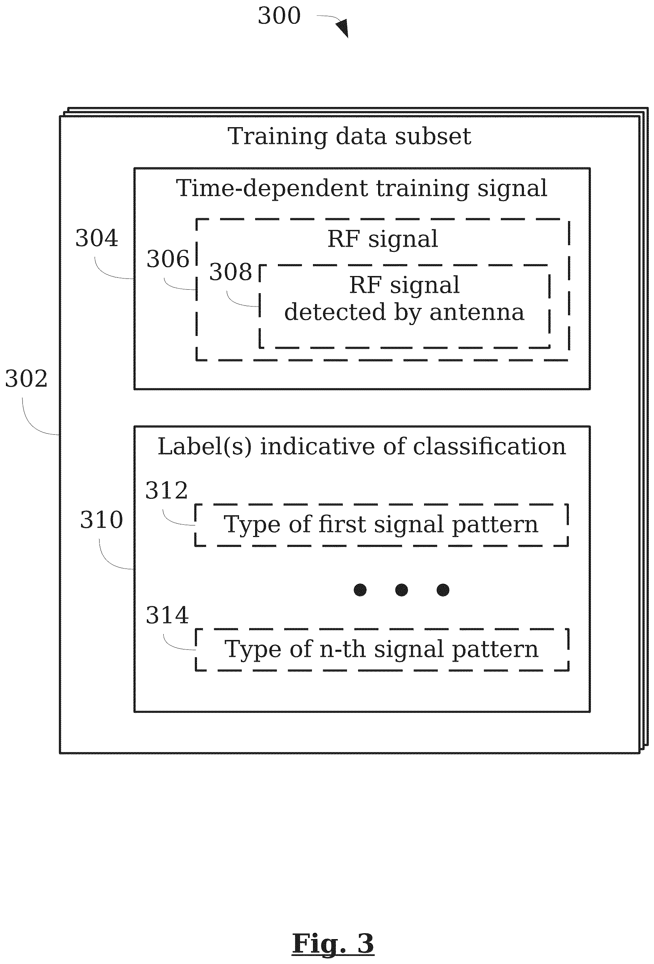

**Figure 1** shows a flow chart of a method 100 of providing an object classifier. The method 100 begins by receiving, 102, a training dataset. The training dataset may comprise the training dataset of **Figure 3.** The training dataset comprises time-dependent signals and labels indicating a classification of the time-dependent signals. The signals include periodic signals at a plurality of different frequencies. The labels can serve as a ground truth for the training process.

At 104, the method performs a plurality of time-frequency transforms (TF transforms) of the time-dependent signals. The time-frequency distributions (TF distributions) created by each of the TF transforms can be provided as two-dimensional arrays. Typical TF transforms yield an output with complex values, which is referred to as a complex time-frequency representation. The squared magnitude of the complex or real time-frequency representation $X(t, f)$ is referred to as a spectrogram:

$$M(t,f) = |X(t,f)|^2$$

. A TF distribution may include a complex time-frequency representation, a real-valued time-frequency representation, or a spectrogram. Supplying a spectrogram to the object classifier is preferred to reduce complexity and to increase compatibility with existing object classifiers, which are configured to receive real-valued inputs. The first dimension of the array is time, and the scaling in time may have the same or a different sampling rate as the input signal frequency. The second dimension of the array is frequency.

The use of TF transforms means conversion of the signal into a format that can be well processed by an object classifier, and in particular better than when supplying the signal to the input of the object classifier itself. Moreover, using more than one TF transform allows benefitting from the advantages of each of the TF transforms, e. g. stability with regard to noise and/or nonlinearities in the signal. Disadvantages of the different TF signals that are specific to a particular transform, such as numerical artifacts, affect the processing by the object classifier less since errors are practically canceled out.

The parameters of the TF transforms may be chosen independently from the training and kept at a fixed value, or varied as hyperparameters. However, it is preferred to vary the parameters by training, i. e. the TF transforms are preferably trained together with the object classifier to classify the signal. This provides more appropriate settings of the TF transforms and thus a more accurate classification.

Determining TF distributions may include determination of a short-term Fourier transform (STFT) of the training signal, 106. During training, a window size of the STFT may be determined at 108. Determining the TF distributions may include performing a Capon transform, 110. Determining a time frequency distributions may further include determining a Wigner-Ville distribution 112.

The output of the TF transforms can be either supplied directly to the object classifier, but it is preferred to perform a reassignment on one or more of the TF distributions first, as in step 114. This improves processing by the object classifier. The reassignment operation includes assigning, or shifting, a value of the TF distribution to the position in time-frequency space where it contributes most to the signal reconstruction. In other words, reassignment includes mapping the data of a TF distribution to coordinates in time-frequency space that are closer to a true region of support of the analyzed signal. Thereby, information on the phase of the signal is taken into account to provide a TF distribution that allows more precise and reliable analysis by the object classifier.

At 116, the TF distributions are supplied to an input of an object classifier. In an example, the input of the object classifier comprises a plurality of input channels of identical size, and each of the TF distributions is supplied to one input channel. A combination of TF distributions is supplied, including different or identical TF distributions, with or without reassignment.

At 118, the object classifier is trained. Training includes a process of supervised learning in which weights of the object classifier are adjusted to improve classification of the signal. The classification of the signal may include the detection of one or more signal features within the training signal as described with reference to **Figure 3.**

The object classifier may thus be trained to predict the presence of a signal pattern in the training signal. The trained object classifier is usable for classifying a signal pattern in an input signal, which may comprise a radio-frequency signal, for example by the method of the second aspect of the present disclosure.

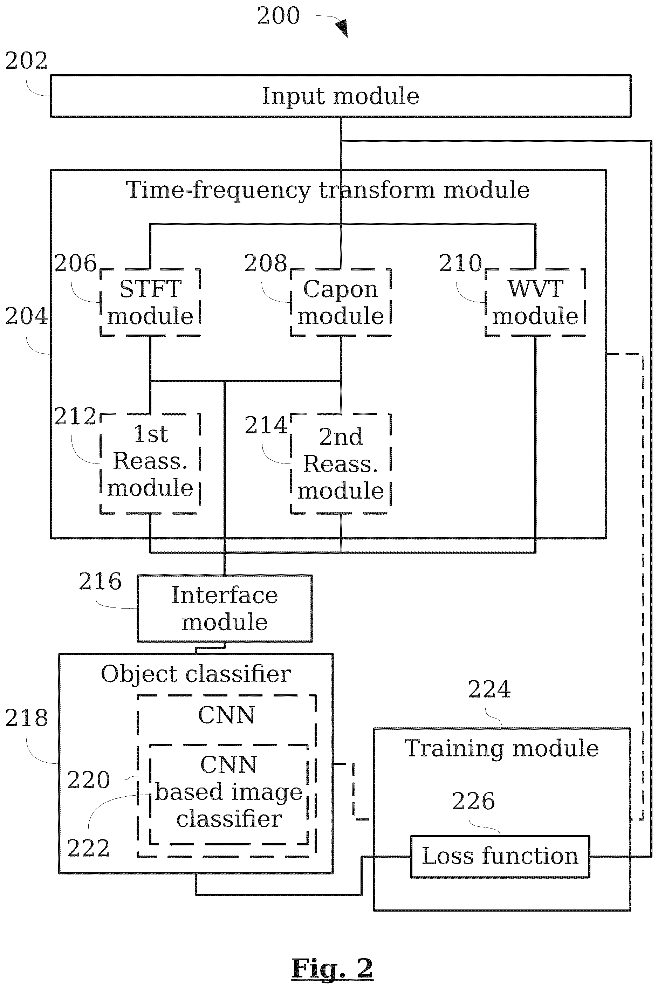

**Figure 2** shows a block diagram of a system 200 for providing an object classifier. The system 200 may be implemented in hardware and/or in software. The system 200 comprises an input module 202 that is configured to receive a training dataset, for example a training dataset as defined in **Figure 3.** The input module 202 may comprise a suitable interface for receiving data, such as a network controller, a camera, and/or any human interface device.

The system 200 further comprises a TF transform module 204 comprising means for performing the TF transforms, which may include processors and memory devices configured to execute the steps 104-112 of method 100. Each of the transforms has its individual advantages and drawbacks. Therefore, each of the transforms can yield different parts of the information in the time-dependent signal to the object classifier. The use of more than one TF transform therefore has the benefit that the object classifier is provided with more information, so that information loss due to the disadvantages of the methods is less prone to impede classification. For example, low resolution in time of one of the distributions may be in part remedied by supplying another transform in parallel to the classifier that provides higher time resolution. Likewise, numerical artifacts caused by a transform are less likely to lead to wrong classification results if a second transform is used in parallel that does not produce these artifacts.

The TF transforms provide a fixed time-frequency resolution, i. e. the time resolution of the time-frequency distributions is the same for all frequencies, and its frequency resolution is the same for all times. Therefore, two signal patterns that differ only in frequency can be classified consistently.

The STFT module, 206, is configured to execute step 106, and preferably step 108 of method 100. The use of an STFT has the advantage that it produces distributions that are easy to interpret. The STFT does not produce numerical artifacts. Moreover, there are fast implementations of STFT, including the Fast Fourier Transform (FFT) algorithm. An STFT includes moving a sliding window over the signal, which may be specified by a window function $w(t)$. The STFT results in the following time-frequency distribution depending on time $t$ and frequency $f$ based on the time-dependent signal $x(t)$:

$$S(t,f) = \int_{-\infty}^{\infty} x(t_1)w^*(t_1 - t)\, e^{-j2\pi f t_1}\, dt_1$$

The star denotes the complex conjugate, and j is the imaginary unit.

The window function w may be a Gaussian function: $w_G(t) = e^{-\alpha t^2}$.

The window function can be parameterized by a window size, i. e. a parameter that determines the extent of the window, such as a standard deviation $1/\sqrt{2\alpha}$, of the Gaussian. However, also other window functions, such as a Kaiser window, may be used:

$$w_K(t) = I_0\left(\beta\sqrt{1 - \left(\frac{t - \frac{N}{2}}{\frac{N}{2}}\right)^2}\right)/I_0(\beta)$$

Here, $I_0$ is the zeroth order modified Bessel function of the first kind. N is the window length. $\beta$ is the shape parameter for the window. It is preferred to choose the window length as a hyperparameter, and to determine the shape parameter by training. In this way, the detection is adapted to a given length of an active pattern by approaching an optimal tradeoff between the frequency resolution and the level of the side lobes of the Kaiser window in frequency space.

Referring to STFTs in general, a given time interval is selected by the window function, and a Fourier transform is calculated that represents the frequency content of that time span. The window size thus allows controlling the time and frequency resolution. A low window size allows capturing a short time interval and has thus a high time resolution. However, the frequency resolution is low because the windowed signal comprises only limited frequency information due to the uncertainty principle. A large window size, in turn, provides low time resolution and high frequency resolution. Therefore, the time-frequency transforms may comprise two or more STFTs with different window sizes.

The Capon module, 208, is configured to execute step 110 of method 100. A Capon transform is an application of Capon spectrum beamforming to generate a time-frequency distribution and has been described in Stanković et al. "On the Capon's Method Application in Time-Frequency Analysis", Proceedings of the 3rd IEEE International Symposium on Signal Processing and Information Technology (IEEE Cat. No.03EX795), Darmstadt, Germany, 2003, pp. 721-724, doi: 10.1109/ISSPIT.2003.1341222. Advantages of the Capon transform include the following: The Capon spectrogram and the STFT spectrogram have the same performance with respect to the instantaneous frequency estimation for one component signal. Also, the Capon spectrogram is better concentrated in the time-frequency space than the STFT spectrogram. Moreover, a Capon spectrogram can resolve a plurality of frequency components at an appropriate instant in time.

For a sampled signal

$$\boldsymbol{x}(t) = \begin{pmatrix} x(t) \\ x(t+1) \\ \dots \\ x(t+N-1) \end{pmatrix}$$

a general expression of a Capon transformation of the signal is

$$C(t, \omega) = \frac{1}{\boldsymbol{a}^\dagger(\omega)\hat{R}_x^{-1}(t)\boldsymbol{a}(\omega)}$$

where

$$\boldsymbol{a}(\omega) = \begin{pmatrix} 1 \\ e^{j\omega} \\ \dots \\ e^{j\omega(N-1)} \end{pmatrix}$$

where $\omega$ is the frequency and j is the imaginary unit, and

$$\hat{R}_x^{-1}(t) = E\{\boldsymbol{x}(t)\boldsymbol{x}^\dagger(t)\}$$

is the autocorrelation matrix. Here, the dagger denotes the Hermitian transpose.

The transform can also be determined as

$$C\left(t,f\right) = \frac{\rho}{N - (E + \rho)^{-1}|S(t,f)|^2}$$

Here, E is the energy of the input function $x(t, f)$, and $S(t, f)$ is the STFT of the input function $x(t, f)$, as defined above.

The Capon transform is particularly accurate for signals with high signal-to-noise ratio. Fast implementations exist. It offers high resolution. It does not produce new numerical artifacts. Therefore, it is preferred to combine a Capon transform with an STFT in order to have two different transforms that are fast and whose errors cancel each other out.

The Wigner-Ville transform module, 210, is configured to execute step 112 of method 100. Using a Wigner-Ville transform means multiplying the signal pointwise with a lagged version of itself and then integrating over time. It produces a Wigner-Ville distribution depending on time $t$ and frequency $f$ based on the time-dependent signal $x(t)$:

$$W\left(t,f\right) = \int_{-\infty}^{\infty} x\left(t + \frac{\tau}{2}\right)x^*\left(t - \frac{\tau}{2}\right)e^{-j2\pi f\tau}d\tau$$

Again, the star denotes the complex conjugate, and j is the imaginary unit. The Wigner-Ville distribution is always real-valued. Either its output value $W(t, f)$, or the square of the output values, $|W(t, f)|$, referred to herein as the spectrogram, may be supplied to the object classifier.

The Wigner-Ville transform has a higher resolution than an STFT or the Capon transform. However, implementations of Wigner-Ville transform are slower compared to STFT and Capon transforms and thus the use of only the latter is preferred if fast processing is a priority.

The first reassignment module, 212 and the second reassignment module, 214 are configured to perform a reassignment of the STFT and Capon distributions, respectively. The reassignment algorithms may be the same for both. They include using the phase information of the distribution to shift the time-frequency coordinates of the TF signal using the stationary point theorem. If $\varphi$ is the phase of the transform, the coordinates shift as follows:

$$f \rightarrow f - \frac{\partial\varphi}{\partial t}$$

$$t = t - \frac{\partial\varphi}{\partial f}$$

A preferred example for use with radio-frequency signals comprises three different TF transforms applied in parallel, which has been shown to result in a particular improved training/classification process:

- The STFT is used without reassignment as a general-purpose transform that produces reliable TF distributions for most input data. The window size of the STFT is set before training. Use of STFT in parallel to the other techniques also allows the object classifier 220 to dismiss any numerical artifacts, such as cross terms occurring in the other transforms that would otherwise degrade the reliability of the classification.
- The STFT is used with reassignment to obtain a higher resolution in time and frequency. This allows distinguishing, by the object detector, two signal features that are in proximity in time, or frequency, or both.
- The Capon transform is used to extract a higher resolution. This leads to an overall improved performance if the training / input signals have a high signal-to-noise ratio.

The use of three real-valued transforms has the advantage that existing classifiers with three real-valued inputs can be used. For example, the TF distributions can be fed into the three inputs of the YOLO classifier as described below.

Returning to Fig. 2, the interface module 216 is adapted to supply the distributions to the object classifier. It may comprise logic to transform the TF distributions to a data format that the object classifier 218 accepts, for example by determining the absolute square of the TF distribution values, or by cutting or padding the TF distributions to fit an input array size of the object classifier 218.

The object classifier 218 includes a machine learning algorithm. Applying machine learning has the advantage of improved use of the information in the TF transforms. A machine learning algorithm can learn by training from examples which of the TF transforms can be relied upon to obtain highest resolution and which features in the TF distributions to dismiss as artifacts. The use of machine learning also allows generalizing the object classification beyond features that are described and quantified by an algorithm. Moreover, the complexity of the system is reduced on a conceptual level.

It is preferred to use a convolutional neural network (CNN) 220. The CNN 220 comprises a plurality of layers, in particular an input layer, one or more hidden layers, and an output layer. The layers comprise nodes connected by edges. Edges are assigned weights. At least one of the hidden layers is a convolutional layer, i. e. a layer that by its structure forms a convolution operation.

The use of a convolutional layer allows processing a comparably large array comparably fast. Therefore, signals can be processed in real time at a high temporal and frequency resolution, although the latter leads to large TF distributions. A CNN is particularly well suited for detecting signal patterns in the training signal when used in combination with a constant time-frequency resolution: The TF transforms produce TF distributions in which the signal patterns is the same pattern if detected at another time or shifted in frequency. The CNN 220 is invariant as to translation of the signal pattern on the array. Thus, the signal pattern is detected consistently.

In an example, a CNN based image classifier 222 is used. CNN-based image classifiers are adapted to and perform well when used on arrays. Fast implementations exist. An example of a CNN-based image classifier is YOLO (You Only Look Once), as described in arXiv:1506.02640v5 [cs.CV]. It can be trained by specifying bounding boxes and object classes as labels. It allows detection at 45 frames per second, well suited for real time detection. Moreover, YOLO features three input channels, which may be used to process color images in other applications. YOLO may be used without any modifications to its structure by supplying three different TF distributions to its input, one to each channel.

The training module 224 is configured to train the object classifier to predict the classifications. Training includes determining the weights of the object classifier. Training module 224 is configured to receive the labels from the input module as a ground truth and the result determined by the object detector, and to determine a loss using loss function 226.

In order to train the object classifier to detect types, frequency intervals, and time intervals of signal patterns, it is preferred to use a multi-part loss function 226 that determines the loss depending on an error in classification, error in position of the beginning and end of the time and frequency intervals. Depending on the output of loss function 226, training includes adjusting parameters of the object classifier 218, such as weights of CNN 220, to reduce the loss determined by the loss function 226.

**Figure 3** shows a block diagram of a structure of a training dataset 300. The training dataset 300 comprises a plurality of training data subsets 302. Each of the training data subsets 302 comprises a time-dependent training signal 304 and a label 310 indicative of one or more classifications of the training signal 304. The training signals 304 may be generated by receiving and recording wireless signals.

The labels 310 may be generated by hand as follows. A corresponding training signal 304 of the same training data subset 302 is processed by one or more time-frequency transforms, for example one of the time-frequency transforms 104, which may be adjusted by hand to obtain a time-frequency distribution that is well classifiable to a human labeler. The human labeler identifies on a spectrogram and/or a representation of the imaginary part of the spectrogram a classification of the training signal 304, for example the positions and types of one or more signal patterns. Moreover, a priori information on the signals may be used if the training signals 304 were recorded in a known configuration, i. e. known devices sending and their signals being received.

The training dataset 300 may also be generated synthetically by generating one or more artificial signal patterns using a frequency generator, and adding artificial noise. In this case, the labels 310 may simply indicate the settings that were used to control the frequency generator.

The training signal 304 is specified as instantaneous signal strength depending on time. It is preferably specified as in-phase and quadrature components. As the signal depends on one parameter, namely time, it may have the format of a vector, and the scaling in time may be provided as a sampling rate. It is preferred to train the object classifier and/or TF transforms on a dataset that is similar to that used during the test phase. Therefore, the training signal 304 may comprise a radio-frequency (RF) signal 306, and in particular an RF signal 308 detected by an antenna. The value of the signal may be proportional to an instantaneous magnitude of the RF signal. The training signal 304 may comprise a synthetic signal, e. g. an artificial signal generated to improve training of the object classifier. For example, a synthetic signal may be determined as an adversarial example for adversarial training. The length of the training signal 304 may be standardized so that the TF transforms have a consistent size.

Training signal 304 may or may not comprise one or more signal patterns. A signal patterns is a pattern in the training signal 304 that is localized in frequency and time. In particular, a signal pattern is present where the magnitude of the training signal 304 is increased during a finite frequency and/or time interval. It may be identified in the TF transform as being in a rectangle defined by a time interval and a frequency band. For example, an RF signal detected by an antenna may indicate the electromagnetic waves received by the antenna during a predetermined first time interval and at a first frequency band that the antenna is sensitive to. A signal pattern may relate to energy transmitted by an active sensor. An active sensor is a sensor that transmits energy and uses the energy for measuring attributes of a target, for example a radar device that detects a target. A signal pattern within the training signal 308 may correspond to a second time interval within the first time interval when a signal magnitude is increased at a second frequency interval within the first frequency interval. This signal pattern may be caused by a remote device sending within the second frequency interval during the second time interval. A plurality of signal patterns may be comprised in the training signal, each caused by a remote device, which can be the same or a plurality of remote devices. The task of classifying the training signal may include detecting the presence of one or more signal patterns at a predetermined frequency interval and/or a predetermined time interval. This allows determining a given remote device is sending a signal, at which time and at which frequency it is sending. This could be referred to as solving the problem of classification with missing inputs: Not every training signal corresponds to a class, i. e. comprises a signal pattern, and a training signal may correspond to more than one class at the same time, i. e. comprise a plurality of signal patterns.

The label 310 indicates a classification of the signal. In particular, each label 310 relates to a training signal and may denote the presence of one or more signal patterns. Each label 310 may comprise an n-tuple of items 312, 314, each item 312, 314 denoting a signal pattern or a type of a signal pattern. Each item 312, 314 may include an identifier of the signal pattern given as a unique number for identifying a type of signal, an individual remote device, a type of remote device and/or a configuration of a remote device. Like this, Each item 312, 314 may further include a time and/or frequency interval denoting the position of the signal pattern in time-frequency space, as a bounding box. This allows the object classifier to detect the signal pattern independently of where the signal is located on the spectrogram. That is, the signal is detected regardless of the moment in time when it was received, and regardless of the frequency at which it was received. Thereby, signals that are identical except that they were tuned to a different carrier frequency are consistently recognized. This advantage is facilitated by the use of time-frequency transforms with constant time-frequency resolution.

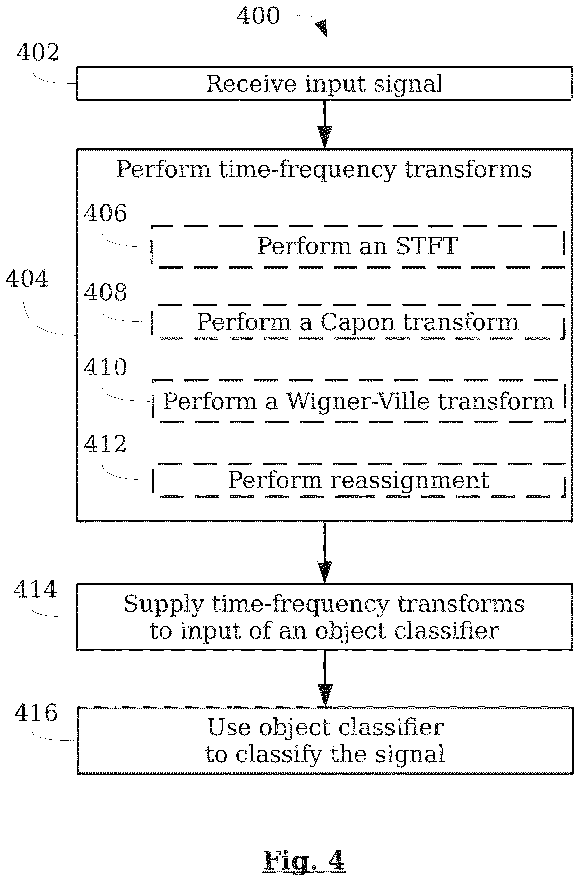

**Figure 4** shows a flow chart of a method 400 of radio-frequency signal processing. The method 400 relates to using time-frequency distributions to preprocess an input signal, and using an object classifier to classify the preprocessed input signal. At 402, the method begins by receiving an input signal. The input signal may include any time-dependent signal, and its type and content depend on the application. Applications may include processing of RF signals, acoustic signals, and/or other signals that contain a periodicity. It is preferred to use the method to classify an RF signal detected by an antenna. This allows real-time processing of an input of a radio device.

At 404, a plurality of time-frequency distributions of the input signal is determined. This may include performing an STFT, 406, a Capon transform 408, a Wigner-Ville transform, and/or reassignment of any of the TF distributions, 412. These algorithms correspond to steps 106-114 of method 100, and different combinations of the algorithms may be used. It is preferred to use the same combination of algorithms as discussed with reference to method 100. The use of a combination of STFT and Capon transform with and without reassignment is particularly advantageous because these transforms, as well as object classifiers, are fast enough to process the input signal in real time. In particular, it is preferred to train, using method 100, an object detector and the time-frequency transforms, and then use these trained algorithms to classify similar RF signals without changing any parameters of the transforms and the object classifier.

At 414, the time-frequency transforms are supplied to the input of an object classifier. This step can be executed similarly to step 116 of method 100.

At 416, the object classifier is used to classify the signal. It is preferred to use a trained object classifier, in particular the trained object classifier produced by the method 100.

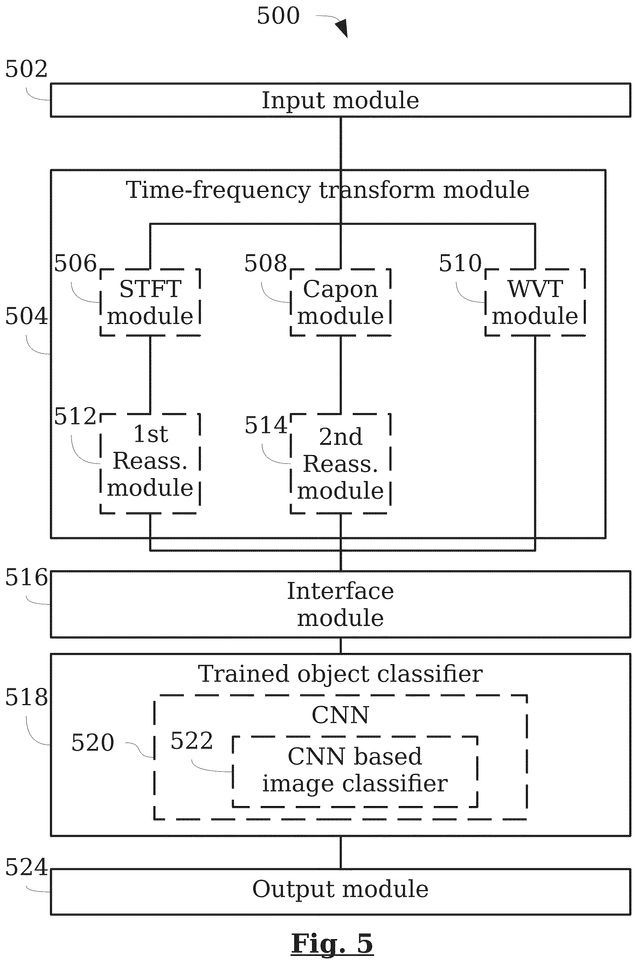

**Figure 5** shows a block diagram of a system 500 for detecting a signal pattern comprised in a time-dependent input signal. The system 500 comprises input module 502, which may be similar to input module 202 of the system 200. It is preferred that the input module 502 is connected to a radio receiver 702 of radio device 700, so that the input module 502 receives a radio signal. The input module may be configured to cut the input the radio signal in fixed-size segments to facilitate processing by the other modules of the system 500.

The system 500 further includes a time-frequency transform module 504, which includes an STFT module 506, a Capon module 508, and a WVD module 510, as well as a first reassignment module 512 and a second reassignment module 514. These modules may be similar or identical to the corresponding modules 204-214 of system 200. In a preferred example, the TF transforms are STFT without reassignment, STFT with reassignment, and Capon transform, which can be used with the trained YOLO classifier, similarly as described with respect to Fig. 2.

The system 500 further includes an interface module 516. The interface module 516 may be similar to interface module 216 of system 200.

The system 500 further includes an object classifier 518. The object classifier 518 may be trained to classify the input signals according to step 516 of method 400. It may be provided by the method 100 and/or the system 200 of **Figure 2.** It may include a CNN 520, in particular a CNN based image classifier 522, trained by the method 100 and/or system 200.

The system 500 further includes an output module 524. The output module 524 is configured to communicate the result of the classification by the object classifier and may include human interface devices and/or network devices.

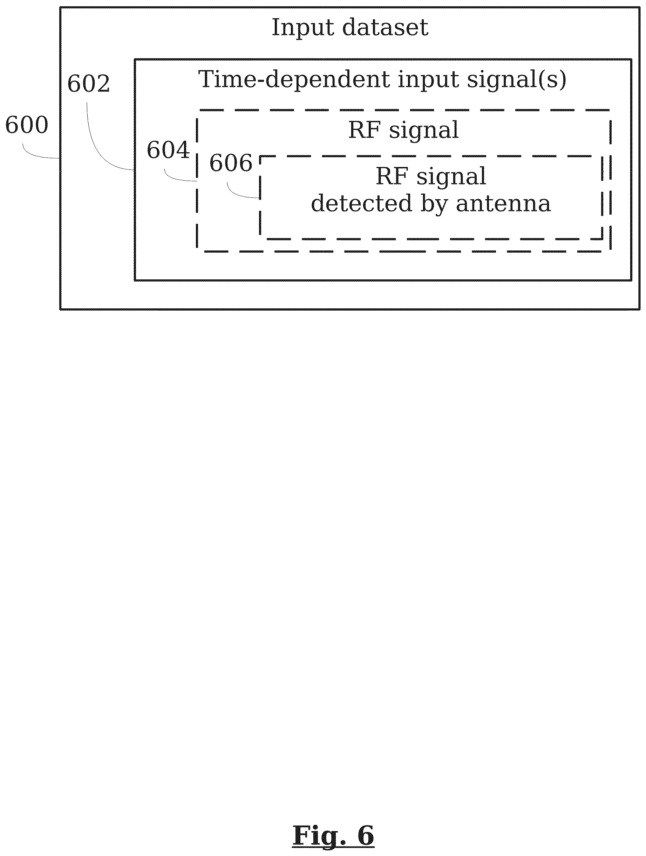

**Figure 6** shows a block diagram of a test dataset 600. The test dataset 600 comprises one or more time-dependent test signals 602, which may comprise one or more RF signals 604, in particular one or more RF signals detected by an antenna 606. The above may include any of the specifics of the time-dependent training signals 304 described with reference to **Figure 3**. The system 500 **(Figure 5)** may then be adapted classify the input signals 602 by determining the presence of one or more signal patterns in each of the input signals 602. Analogously to signal patterns in the training signals, signal patterns in the training signal are patterns that are localized in frequency and time.

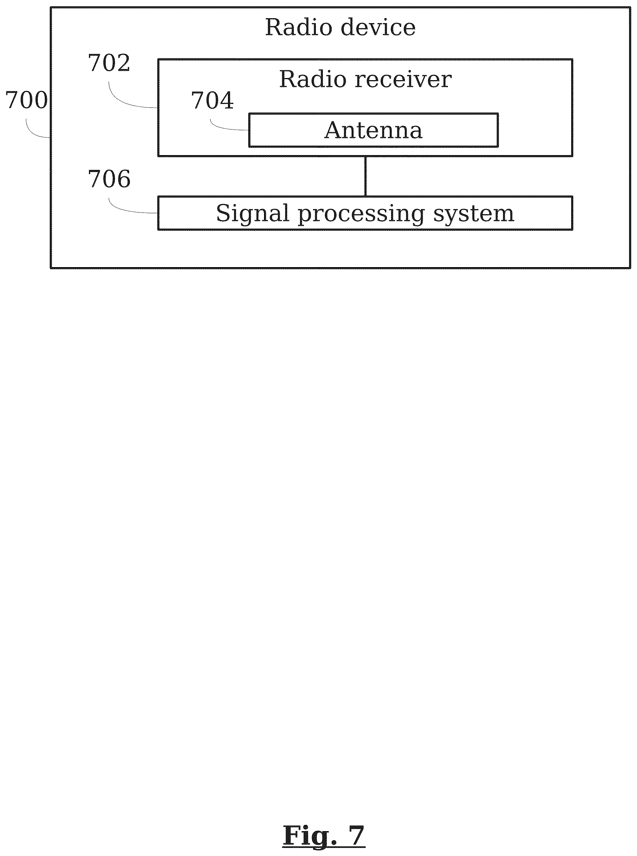

**Figure 7** shows a block diagram of a radio device 700. The radio device 700 comprises a radio receiver 702 that is coupled to signal processing system 706. The radio receiver comprises an antenna 704 and, preferably, an amplifier circuit to amplify the signal to provide a high signal-to-noise ratio. The radio receiver 702 may be operable to receive, from a user, an indication of a predetermined frequency band and a predetermined time interval. The radio receiver may record an RF signal detected by the antenna 704 at said frequency band and time interval. The radio receiver 704 may then output the signal to the system 706.

The system 706 may be identical or similar to the system of **Figure 2** or the system of **Figure 5.** System 706 may comprise a processor and be operable to receive the RF signal from the radio receiver 704.

"When the terms "radio frequency spectrum", "radio frequency signal" or a similar term is used anywhere in the present disclosure (relating to any of the described embodiments), any electromagnetic spectrum or any electromagnetic signal may be meant, in particular signals with frequencies in the range of approx. 3 Hz to approx. 3,000 GHz. The present disclosure is not restricted to specific signal frequencies in this regard.

## Further examples

Example 1. A computer-implemented method of providing a trained object classifier for radio-frequency signal processing, the method comprising:

receiving (102) a training dataset (300) comprising one or more time-dependent training signals (304) and one or more labels (310) indicative of classifications of the training signals;
performing (104) a plurality of different time-frequency transforms of the training signals (304) to determine a plurality of time-frequency distributions;
supplying (116) the time-frequency distributions to an input of an object classifier (218); and
training (118) the object classifier (218) to classify the training signal.

Example 2. The computer-implemented method of example 1,

wherein the time-frequency transforms have a constant time-frequency resolution; and/or
wherein the time-frequency distributions include one or more spectrograms.

Example 3. The computer-implemented method of any of the preceding examples,

wherein performing (104) the time-frequency transforms of the training signal comprises performing (106) a short-time Fourier transform, STFT, of the training signal; and
wherein performing (106) an STFT preferably further comprises adjusting (108) a size of a window of the STFT.

Example 4. The computer-implemented method of any of the preceding examples, wherein performing (104) the time-frequency transforms of the training signal comprises one or more of:

performing (110) a Capon transform of the training signal; and/or
performing (112) a Wigner-Ville transform of the training signal.

Example 5. The computer-implemented method of any of the preceding examples, wherein performing (104) the time-frequency transforms of the training signal comprises performing a reassignment of one or more of the determined time-frequency distributions, in particular performing an STFT (106) and/or a Capon transform (110) of the training signal, each followed by performing (114) a reassignment of the distribution generated by the STFT and/or Capon transform.

Example 6. The computer-implemented method of any of the preceding examples, wherein the object classifier (218) comprises a machine learning module, preferably comprising a neural network, more preferably comprising a convolutional neural network, CNN (220), and/or wherein the object classifier comprises a, preferably CNN-based, image classifier (222).

Example 7. A computer-implemented method of radio-frequency signal processing, the method comprising:

receiving (402) a time-dependent input signal (602);
performing (404) a plurality of time-frequency transforms of the input signal (602) to determine a plurality of time-frequency distributions;
supplying (414) the time-frequency distributions to an input of a trained object classifier (518); and
classifying (416), in particular obtaining an output signal indicative of a classification of, the input signal (602) by the trained object classifier (518).

Example 8. The computer-implemented method of example 7,

wherein the trained object classifier (518) was trained using the method of any of examples 1-6;
wherein the time-frequency transforms of the input signal (602) have a constant time-frequency resolution; and/or
wherein the time-frequency distributions include one or more spectrograms.

Example 9. The computer-implemented method of example 7 or example 8, wherein performing (404) the time-frequency transforms of the input signal (602) comprises one or more of:

performing (406) an STFT of the input signal;
performing (408) a Capon transform of the input signal;
performing (410) a Wigner-Ville transform of the input signal;
performing a reassignment operation (412) on a time-frequency distribution; and/or
performing an STFT (406) or a Capon transform (408) of the input signal followed by performing a reassignment operation (412).

Example 10. The computer-implemented method of any the preceding examples, wherein the time-dependent training signals (304) and/or the time-dependent input signal (602) comprise a radio frequency, RF, signal (306, 604), in particular an RF signal (308, 606) detected by an antenna (704).

Example 11. A system (200) for providing an object classifier for radio-frequency signal processing, the system (200) comprising one or more processors and one or more storage devices, wherein the system is configured to perform the computer-implemented method of any one of examples 1-6.

Example 12. A system (500) for radio frequency signal processing, the system comprising one or more processors and one or more storage devices, wherein the system is configured to perform the computer-implemented method of any one of examples 7-10.

Example 13. A radio device (700), comprising the system of example 12 (706) and a radio receiver (702) operable to receive the time-dependent input signal (602).

Example 14. A computer program product for loading into a memory of a computer, comprising instructions, that, when executed by a processor of the computer, cause the computer to execute a computer-implemented method of any of examples 1-10.

Example 15. A computer program product comprising a trained object classifier (518) obtainable by the computer-implemented method of any of examples 1-6.

### Reference signs

List of reference signs:

| | |
|---|---|
| 100 | Method of providing an object classifier |
| 102-118 | Steps of method 100 |
| 200 | System for providing an object classifier |
| 202 | Input module |
| 204 | Time-frequency transform module |
| 206 | Short-term Fourier transform module |
| 208 | Capon transform module |
| 210 | Wigner-Ville transform module |
| 212 | First reassignment module |

| 214 | Second reassignment module |
| 216 | Interface module |
| 218 | Object classifier |
| 220 | CNN |
| 222 | CNN based image classifier |
| 224 | Training module |
| 226 | Loss function |
| 300 | Training dataset |
| 302 | Training data subset |
| 304 | Time-dependent training signal(s) |
| 306 | RF signal(s) |
| 308 | RF signal(s) detected by an antenna |
| 310 | Label(s) indicative of a classification |
| 312, 314 | Types of signal patterns |
| 400 | Method of radio-frequency signal processing |
| 402-416 | Steps of method 400 |
| 500 | System for radio-frequency signal processing |
| 502 | Input module |
| 504 | Time-frequency transform module |
| 506 | Short-term Fourier transform module |
| 508 | Capon transform module |
| 510 | Wigner-Ville transform module |
| 512 | First reassignment module |
| 514 | Second reassignment module |
| 516 | Interface module |
| 518 | Trained object classifier |
| 520 | CNN |
| 522 | CNN based image classifier |
| 524 | Output module |
| 600 | Input dataset |
| 602 | Time-dependent input signal(s) |
| 604 | RF signal(s) |
| 606 | RF signal(s) detected by an antenna |
| 700 | Radio device |
| 702 | Radio receiver |
| 704 | Antenna |
| 706 | Signal processing system |

**Claims**

1. A computer-implemented method of providing a trained machine learning module for radio-frequency signal processing, the method comprising:

   receiving (102) a training dataset (300) comprising one or more time-dependent training signals (304) and one or more labels (310) indicative of classifications of the training signals;
   performing (104) a plurality of different time-frequency transforms of the training signals (304) to determine a plurality of time-frequency distributions;
   supplying (116) the time-frequency distributions to an input of a machine learning module (218); and
   training (118) the machine learning module (218) to classify the training signal,
   **characterized in that** the machine learning module is a You Only Look Once image classifier.

2. The computer-implemented method of claim 1,

   wherein the time-frequency transforms have a constant time-frequency resolution; and/or
   wherein the time-frequency distributions include one or more spectrograms.

3. The computer-implemented method of any of the preceding claims,

wherein performing (104) the time-frequency transforms of the training signal comprises performing (106) a short-time Fourier transform, STFT, of the training signal; and

wherein performing (106) an STFT preferably further comprises adjusting (108) a size of a window of the STFT.

4. The computer-implemented method of any of the preceding claims, wherein performing (104) the time-frequency transforms of the training signal comprises one or more of:

performing (110) a Capon transform of the training signal; and/or
performing (112) a Wigner-Ville transform of the training signal.

5. The computer-implemented method of any of the preceding claims, wherein performing (104) the time-frequency transforms of the training signal comprises performing an STFT (106) and/or a Capon transform (110) of the training signal, each followed by performing (114) a reassignment of the distribution generated by the STFT and/or Capon transform.

6. The computer-implemented method of any of the preceding claims, wherein the machine learning module (218) comprises a neural network, preferably comprising a convolutional neural network, CNN (220), and/or wherein the machine learning module comprises a, preferably CNN-based, image classifier (222).

7. A computer-implemented method of radio-frequency signal processing, the method comprising:

receiving (402) a time-dependent input signal (602);
performing (404) a plurality of time-frequency transforms of the input signal (602) to determine a plurality of time-frequency distributions;
supplying (414) the time-frequency distributions to an input of a trained machine learning module (518); and
classifying (416), in particular obtaining an output signal indicative of a classification of, the input signal (602) by the trained machine learning module (518) ,
**characterized in that** the machine learning module is a You Only Look Once image classifier.

8. The computer-implemented method of claim 7,

wherein the trained machine learning module (518) was trained using the method of any of claims 1-6;
wherein the time-frequency transforms of the input signal (602) have a constant time-frequency resolution; and/or
wherein the time-frequency distributions include one or more spectrograms.

9. The computer-implemented method of claim 7 or claim 8, wherein performing (404) the time-frequency transforms of the input signal (602) comprises one or more of:

performing (406) an STFT of the input signal;
performing (408) a Capon transform of the input signal;
performing (410) a Wigner-Ville transform of the input signal; and/or
performing an STFT (406) or a Capon transform (408) of the input signal followed by performing a reassignment operation (412).

10. The computer-implemented method of any the preceding claims, wherein the time-dependent training signals (304) and/or the time-dependent input signal (602) comprise a radio frequency, RF, signal (306, 604), in particular an RF signal (308, 606) detected by an antenna (704).

11. A system (200) for providing a machine learning module for radio-frequency signal processing, the system (200) comprising one or more processors and one or more storage devices, wherein the system is configured to perform the computer-implemented method of any one of claims 1-6.

12. A system (500) for radio frequency signal processing, the system comprising one or more processors and one or more storage devices, wherein the system is configured to perform the computer-implemented method of any one of claims 7-10.

13. A radio device (700), comprising the system of claim 12 (706) and a radio receiver (702) operable to receive the time-dependent input signal (602).

**14.** A computer program product for loading into a memory of a computer, comprising instructions, that, when executed by a processor of the computer, cause the computer to execute a computer-implemented method of any of claims 1-10.

100

102

Receive training dataset

104

Perform time-frequency transforms

106

Perform an STFT

108

Adjust the size of a
window of the STFT

110

Perform a Capon transform

112

Perform a Wigner-Ville transform

114

Perform reassignment

116

Supply time-frequency transforms
to input of an object classifier

118

Train object classifier
to classify the signal

**Fig. 1**

200

202

Input module

Time-frequency transform module

204

206 STFT module

208 Capon module

210 WVT module

212 1st Reass. module

214 2nd Reass. module

216 Interface module

Object classifier

218

CNN

220

222 CNN based image classifier

224 Training module

226 Loss function

**Fig. 2**

300

Training data subset

Time-dependent training signal

RF signal

RF signal
detected by antenna

304

306

308

302

Label(s) indicative of classification

312

Type of first signal pattern

310

● ● ●

314

Type of n-th signal pattern

**Fig. 3**

**400**

**402** Receive input signal

**404** Perform time-frequency transforms

**406** Perform an STFT

**408** Perform a Capon transform

**410** Perform a Wigner-Ville transform

**412** Perform reassignment

**414** Supply time-frequency transforms to input of an object classifier

**416** Use object classifier to classify the signal

**Fig. 4**

500

502 — Input module

504 — Time-frequency transform module

506 — STFT module    508 — Capon module    510 — WVT module

512 — 1st Reass. module    514 — 2nd Reass. module

516 — Interface module

518 — Trained object classifier

520 — CNN

522 — CNN based image classifier

524 — Output module

**Fig. 5**

Input dataset

600

602

Time-dependent input signal(s)

604

606

RF signal

RF signal
detected by antenna

**Fig. 6**

Radio device

702

700

Radio receiver

704

Antenna

706

Signal processing system

**Fig. 7**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **STANKOVIĆ et al.** On the Capon's Method Application in Time-Frequency Analysis. *Proceedings of the 3rd IEEE International Symposium on Signal Processing and Information Technology*, 2003, 721-724